# EUROPEAN PATENT APPLICATION

(11) **EP 4 047 055 A1**
(43) Date of publication of application: **24.08.2022**
(21) Application number: 20876761.6
(22) Date of filing: 13.10.2020
(51) Int. Cl.: C08L 27/12, C08J 9/04, C08J 5/00, H01L 21/3065

(54) **PERFLUOROELASTOMER MOLDED ARTICLE AND PROTECTIVE MEMBER**

(30) Priority: 17.10.2019 JP 2019190257
(71) Applicant: AGC INC., Chiyoda-ku, Tokyo 1008405 (JP)
(72) Inventor: YODOGAWA, Masahide, Tokyo 100-8405 (JP); HONDA, Makoto, Tokyo 100-8405 (JP)
(74) Representative: Müller-Boré & Partner Patentanwälte PartG mbB
(86) International application number: PCT/JP2020/038642
(87) International publication number: WO 2021/075431

(57) **Abstract**

To provide perfluoroelastomer molded product and a protective member, excellent in plasma resistance and fitting property.

A perfluoroelastomer molded product containing no carbon black, and having a shore A hardness of 25 or more and 60 or less, and a protective member comprising the perfluoroelastomer molded product.

## Description

### TECHNICAL FIELD

The present invention relates to a perfluoroelastomer molded product and a protective member.

### BACKGROUND ART

As an adhesive for a member in a semiconductor production apparatus, an adhesive containing a urethane compound or an adhesive containing a silicon compound has been used. Since such an adhesive is inferior in the plasma resistance, a member to protect the adhesive portion from plasma (hereinafter sometimes referred to as a protective member) is required.

Since the portions to which the protective member is to be fitted are in various shapes, the protective member is required not only to have plasma resistance but also to have an appropriate hardness and be readily fitted to portions in various shapes, that is to be excellent in fitting property.

A perfluoroelastomer molded product is known to be excellent in heat resistance, chemical resistance and plasma resistance (Patent Document 1).

Further, Patent Document 2 discloses a perfluoroelastomer molded product which is a foam.

### PRIOR ART DOCUMENTS

### PATENT DOCUMENT

Patent Document 1: Japanese Patent No. 5044999
Patent Document 2: JP-A-2015-174927

### DISCLOSURE OF INVENTION

### TECHNICAL PROBLEM

The perfluoroelastomer molded product disclosed in Patent Document 1 contains carbon black and thereby has high hardness and is insufficient in fitting property.

Further, the perfluoroelastomer molded product which is a foam disclosed in Patent Document 2 also contains carbon black and thereby has high hardness and is insufficient in fitting property.

Further, if a perfluoroelastomer molded product containing carbon black is used in a portion at which plasma is generated in a semiconductor production apparatus, particles may be generated from the perfluoroelastomer molded product.

Under these circumstances, the object of the present invention is to provide a perfluoroelastomer molded product excellent in plasma resistance and fitting property, and a protective member containing it.

### SOLUTION TO PROBLEM

The present inventors have conducted extensive studies and as a result, found that a perfluoroelastomer molded product containing no carbon black and having a shore A hardness within a predetermined range can satisfy the above performance required, and have accomplished the present invention.

The present invention provides the following.
[1] A perfluoroelastomer molded product containing no carbon black, and having a shore A hardness of 25 or more and 60 or less.
[2] The perfluoroelastomer molded product according to [1], which contains no silica.
[3] The perfluoroelastomer molded product according to [1] or [2], which has an asker C hardness of 45 or more and 80 or less.
[4] The perfluoroelastomer molded product according to any one of [1] to [3], which is a foam.
[5] The perfluoroelastomer molded product according to any one of [1] to [4], which is obtained from a perfluoroelastomer composition containing a perfluoroelastomer and a crosslinking agent and containing no carbon black.
[6] The perfluoroelastomer molded product according to any one of [1] to [5], which is obtained by crosslinking a perfluoroelastomer in a perfluoroelastomer composition containing the perfluoroelastomer, a crosslinking agent and a foaming agent and containing no carbon black.
[7] The perfluoroelastomer molded product according to any one of [1] to [6], which has a mass reduction by irradiation with plasma of 10 mass% or less, measured by the following method:
   measurement method: the mass of the perfluoroelastomer molded product in a sheet shape having a thickness of 2 mm is measured, the perfluoroelastomer molded product is irradiated with plasma, washed with pure water and dried, and its mass is measured again.
[8] The perfluoroelastomer molded product according to any one of [1] to [7], wherein the perfluoroelastomer is a perfluoroelastomer crosslinkable by an organic peroxide.
[9] The perfluoroelastomer molded product according to [8], wherein the perfluoroelastomer crosslinkable by an organic peroxide is an elastomer having a perfluoroalkylene group, an elastomer having a perfluoropolyether group or an elastomer having both perfluoroalkylene group and perfluoropolyether group.
[10] The perfluoroelastomer molded product according to any one of [1] to [9], wherein the perfluoroelastomer is a copolymer having units based on tetrafluoroethylene and unites based on a perfluoroalkyl vinyl ether.
[11] The perfluoroelastomer molded product according to any one of [1] to [10], which has a content of carbon black having a particle size within a range of from 2 nm to 800 nm of 3 parts by mass or less per 100 parts by mass of the perfluoroelastomer.
[12] A protective member comprising the perfluoroelastomer molded product as defined in any one of [1] to [11].
[13] The protective member according to [12], which has a size of more than 100% and 250% or less to the size of a space in which the protective member is to be disposed.
[14] The protective member according to [12] or [13], which is to protect a portion which may generate particles by exposure to plasma or a chemical solution in a machine for which the plasma or the chemical solution is used.
[15] The protective member according to any one of [12] to [14], which is a protective member for a semiconductor production apparatus.

### ADVANTAGEOUS EFFECTS OF INVENTION

The perfluoroelastomer molded product containing no carbon black, and having a shore A hardness of 25 or more and 60 or less, of the present invention, is excellent in plasma resistance and fitting property. Further, the protective member containing the perfluoroelastomer molded product of the present invention has plasma resistance and favorable fitting property.

### BRIEF DESCRIPTION OF DRAWINGS

Fig. 1 is a view schematically illustrating a shore A indenter.
Fig. 2 is a view schematically illustrating an asker C indenter.
Fig. 3 is a view schematically illustrating a cross section of a semiconductor production apparatus.
Fig. 4 is a pattern diagram illustrating a cross section of a semiconductor production apparatus.
Fig. 5 is a pattern diagram illustrating an embodiment of a protective member of the present invention.
Fig. 6 is a magnification of Fig. 5.

### DESCRIPTION OF EMBODIMENTS

In the present invention, units in a polymer mean minimum constitution units formed by polymerization of a monomer having a carbon-carbon unsaturated bond. The name of units based on a monomer is represented by the name of the monomer with "units". The same applies to a case where the monomer name is an abbreviated name.

The perfluoroelastomer molded product of the present invention contains no carbon black and has a shore A hardness of 25 or more and 60 or less. The perfluoroelastomer molded product of the present invention contains no carbon black and is thereby excellent in plasma resistance. The perfluoroelastomer molded product has a shore A hardness of 25 or more and 60 or less and is thereby excellent in fitting property.

The carbon black in the present invention is intended for carbon black having a particle size within a range of from 2 nm to 800 nm. Further, in the present invention, "containing no carbon black" means that the amount of carbon black having a particle size within a range of from 2 nm to 800 nm is 3 parts by mass or less, preferably 1 part by mass or less, more preferably 0.5 parts by mass or less, most preferably 0 parts by mass, per 100 parts by mass of the perfluoroelastomer.

The particle size of carbon black is a size of a primary particle size provided by suppliers, and is calculated e.g. by the method of arithmetic average particle size observed with an electron microscope.

### <Perfluoroelastomer molded product>

The perfluoroelastomer molded product of the present invention is obtained from a perfluoroelastomer composition containing a perfluoroelastomer and a crosslinking agent and containing no carbon black.

The perfluoroelastomer molded product of the present invention may be one obtained by crosslinking a perfluoroelastomer in a liquid state or may be one obtained by crosslinking a perfluoroelastomer in a solid state.

Further, the perfluoroelastomer molded product of the present invention is more preferably a foam. Preferably, the perfluoroelastomer molded product of the present invention is obtained by crosslinking a perfluoroelastomer in a perfluoroelastomer composition containing the perfluoroelastomer, a crosslinking agent and a foaming agent and containing no carbon black. More preferably, the perfluoroelastomer molded product of the present invention is obtained by expanding a perfluoroelastomer composition containing a perfluoroelastomer, a crosslinking agent and a foaming agent and containing no carbon black and at the same time crosslinking the perfluoroelastomer in the perfluoroelastomer composition.

### <Perfluoroelastomer composition>

### (Perfluoroelastomer)

The perfluoroelastomer used in the present invention is not particularly limited and is preferably a perfluoroelastomer capable of forming a triazine ring, a perfluoroelastomer crosslinkable by a polyol, a perfluoroelastomer crosslinkable by an organic peroxide, or a fluorinated organosiloxane curable perfluoroelastomer, more preferably a perfluoroelastomer crosslinkable by an organic peroxide.

The perfluoroelastomer crosslinkable by an organic peroxide is not particularly limited so long as it is a perfluoroelastomer having a moiety crosslinkable by an organic peroxide. The moiety crosslinkable by an organic peroxide is not particularly limited. The moiety crosslinkable by an organic peroxide may be a moiety capable of radical reaction and may be specifically a group having an unsaturated bond between two carbon atoms, such as a vinyl group or an allyl group, a group having an unsaturated bond between a carbon atom and an atom other than a carbon atom, such as a ketone or an imine, or a halogen atom. Among them, a halogen atom is preferred, and particularly, an iodine atom or a bromine atom is preferred.

The perfluoroelastomer crosslinkable by an organic peroxide may be an elastomer having a perfluoroalkylene group, an elastomer having a perfluoropolyether group, an elastomer having both perfluoroalkylene group and perfluoropolyether group, or a silicone elastomer having a fluorine atom, and is preferably an elastomer having a perfluoroalkylene group in view of excellence in plasma resistance.

The elastomer having a perfluoroalkylene group is preferably a copolymer having units based on tetrafluoroethylene (hereinafter sometimes referred to as TFE) (hereinafter sometimes referred to as TFE units) and units based on a perfluoroalkyl vinyl ether (hereinafter sometimes referred to as PAVE) (hereinafter sometimes referred to as PAVE units) in view of excellence in plasma resistance.

As PAVE, preferred is one represented by the following formula (1).

CF₂=CF-O-Rf formula (1)

wherein Rf is a C₁₋₂₀ perfluoroalkyl group which may optionally have an etheric oxygen atom.

The number of carbon atoms in Rf is from 1 to 20, preferably from 1 to 8.

PAVE represented by the formula (1) is preferably CF₂=CF-O-CF₃, CF₂=CF-O-CF₂CF₃, CF₂=CF-O-CF₂CF₂CF₃, CF₂=CF-O-CF₂CF(CF₃)OCF₂CF₂CF₃, CF₂=CF-O-CF₂CF₂-O-CF₂CF₃, more preferably CF₂=CF-O-CF₃. PAVE may be used alone or in combination of two or more.

The copolymerization ratio in the copolymer having TFE units and PAVE units is preferably such that TFE units/PAVE units=30 to 80/70 to 20 (molar ratio). Within such a range, excellent rubber properties will be obtained.

The copolymer having TFE units and PAVE units may further have units based on a monomer other than TFE and PAVE, as the case requires.

The copolymer having TFE units and PAVE units may be produced, for example, by polymerizing a monomer component containing TFE and PAVE in the presence of a radical polymerization initiator. The copolymer having TFE units and PAVE units may be produced, for example, by a method disclosed in e.g. WO2010/082633.

As the perfluoroelastomer used in the present invention, in view of excellence in heat resistance and chemical resistance, one containing substantially no hydrogen atom is used. "Containing substantially no hydrogen atom" means that the hydrogen atom content in the perfluoroelastomer used in the present invention is 3 mass% or less. The hydrogen atom content in the perfluoroelastomer used in the present invention is preferably 1 mass% or less, more preferably 0.5 mass% or less, further preferably 0.3 mass% or less, particularly preferably 0.1 mass% or less, most preferably 0 mass%.

In the present invention, the perfluoroelastomer having a hydrogen atom content of higher than 0 mass% and 3 mass% or less may be obtained, for example, by using a chain transfer agent containing a hydrogen atom or a comonomer containing a hydrogen atom.

The chain transfer agent containing a hydrogen atom may, for example, be a linear or cyclic saturated hydrocarbon such as methane, ethane, propane, butane, pentane, hexane or cyclohexane, an alcohol such as methanol, ethanol or propanol, or a mercaptan such as tert-dodecylmercaptan, n-dodecylmercaptan or n-octadecylmercaptan. The chain transfer agent containing a hydrogen atom may be used alone or in combination of two or more. The chain transfer agent containing a hydrogen atom and a chain transfer agent containing no hydrogen atom may be used in combination.

The comonomer containing a hydrogen atom may, for example, be CF₂=CF-O-CH₂CF₃, CF₂=CF-O-CH₂CF₂CF₂CF₃, CF₂=CF-O-CH₂(CF₂CF₂)₂H, CF₂=CF-O-CF₂CF₂CH₂-I, CF₂=CF-O-CF₂CF₂CH₂-Br, CF₂=CF-O-CF₂CF₂(CF₃)-O-CF₂CF₂CH₂-I, CF₂=CF-O-CF₂CF₂(CF₃)-O-CF₂CF₂CH₂-Br, or CH₂=CH-CF₂CF₂CF₂CF₂CF₂CF₂-CH=CH₂. The comonomer containing a hydrogen atom may be used alone or in combination of two or more. The comonomer containing a hydrogen atom may be copolymerized with a comonomer containing no hydrogen atom.

Now, the present invention will be described with reference to a case where the perfluoroelastomer molded product is a foam, as a preferred embodiment of the present invention. However, it should be understood that the embodiment of the present invention is by no means restricted to the following description.

Further, in a case where the after-described protective member contains a perfluoroelastomer molded product which is a foam, when the protective member is fitted, such is assumed that the protective member is pushed by a tapered jig and inserted into a space. Hereinafter, when the fitting property of the protective member of the present invention is evaluated, the degree how the protective member is easily fitted will sometimes be referred to as assembling property.

### (Crosslinking agent)

The crosslinking agent for production of the perfluoroelastomer used in the present invention is not particularly limited. The crosslinking agent may be an organic peroxide or an organic polysiloxane containing a hydrosilyl group in its molecule, and is particularly preferably an organic peroxide. Preferred is an organic peroxide having a one-minute half-life temperature that is a temperature at which half of the amount of the organic peroxide is decomposed in one minute, of from 150 to 250°C, more preferably from 150 to 200°C. As specific examples, dialkyl peroxides such as di-tert-butyl peroxide, tert-butyl cumyl peroxide, dicumyl peroxide, α,α-bis(tert-butylperoxy)-p-diisopropylbenzene, 1,3-bis(tert-butylperoxyisopropyl)benzene, 2,5-dimethyl-2,5-di(tert-butylperoxy)hexane and 2,5-dimethyl-2,5-di(tert-butylperoxy)hexine-3, 1,1-di(tert-butylperoxy)-3,3,5-trimethylcyclohexane, 2,5-dimethylhexane-2,5-dihydroxy peroxide, benzoyl peroxide, tert-butylperoxybenzene, 2,5-dimethyl-2,5-di(benzoylperoxy)hexane, tert-butylperoxymaleic acid, and tert-butylperoxyisopropyl carbonate may be mentioned. The organic peroxide may be used alone or in combination of two or more.

The content of the organic peroxide is, per 100 parts by mass of the perfluoroelastomer, preferably from 0.05 to 10 parts by mass, more preferably from 0.3 to 8 parts by mass, most preferably from 0.5 to 6.5 parts by mass.

### (Foaming agent)

The perfluoroelastomer composition to obtain the perfluoroelastomer molded product of the present invention contains a foaming agent.

As specific examples of the foaming agent, an organic chemical foaming agent, an inorganic chemical foaming agent and a gas foaming agent may be mentioned. The perfluoroelastomer composition containing an organic chemical foaming agent or an inorganic chemical foaming agent starts expanding when heated to a predetermined temperature or higher. By injecting a gas foaming agent to the perfluoroelastomer composition, the gas foaming agent makes bubbles form in the perfluoroelastomer composition.

As the foaming agent, an organic chemical foaming agent or an inorganic chemical foaming agent is preferred, and an organic chemical foaming agent or an inorganic chemical foaming agent which undergoes reaction at a temperature of crosslinking or molding is particularly preferred.

As the organic chemical foaming agent, an azo compound, a nitroso compound or a hydrazine compound may be mentioned, and more specifically, azodicarbonamide, barium azodicarboxylate, N,N-dinitrosopentamethylenetetramine, benzenesulfonyl hydrazine and hydrazodicarbonamide may be mentioned.

As the inorganic chemical foaming agent, sodium hydrogen carbonate may be mentioned.

The content of the foaming agent in the perfluoroelastomer composition of the present invention is not particularly limited, and in the case of the organic chemical foaming agent, its content is, per 100 parts by mass of the perfluoroelastomer, preferably from 0.1 to 20 parts by mass, more preferably from 0.3 to 15 parts by mass, and in the case of the inorganic chemical foaming agent, its content is, per 100 parts by mass of the perfluoroelastomer, preferably from 0.1 to 2 parts by mass, more preferably from 0.1 to 1 parts by mass. When the content of the foaming agent is at least the lower limit, expansion reaction is likely to proceed. When the content of the foaming agent is at most the upper limit, expansion state tends to be uniform.

### (Crosslinking aid)

In a case where a crosslinking agent is used for production of the perfluoroelastomer molded product of the present invention, as the crosslinking aid, it is preferred to use at least one member selected from the group consisting of triallyl cyanurate, triallyl isocyanurate (hereinafter sometimes referred to as TAIC) and trimethallyl isocyanurate. Particularly in view of crosslinking reactivity, the crosslinking aid is more preferably TAIC, and it is particularly preferred to use only TAIC as the crosslinking aid.

In a case where the perfluoroelastomer composition contains the crosslinking aid, the content of the crosslinking aid is, per 100 parts by mass of the perfluoroelastomer, preferably 0.4 parts by mass or less, more preferably 0.2 parts by mass or less, further preferably 0.1 parts by mass or less. When the content of the crosslinking aid is 0.4 parts by mass or less, the perfluoroelastomer molded product obtained by expanding the perfluoroelastomer composition and crosslinking the perfluoroelastomer contained in the perfluoroelastomer composition is in a uniformly expanded state and is excellent in surface smoothness, and is excellent in physical properties such as tensile break strength, heat resistance and chemical resistance.

In a case where the crosslinking aid is used for production of the perfluoroelastomer molded product of the present invention, the lower limit of the content of the crosslinking aid is, per 100 parts by mass of the perfluoroelastomer, preferably 0.001 parts by mass or more, more preferably 0.005 parts by mass or more, most preferably 0.01 parts by mass or more. Within such a range, by the crosslinking aid contained, the perfluoroelastomer molded product will be excellent in physical properties and is excellent in heat resistance and chemical resistance.

In production of the perfluoroelastomer molded product of the present invention, it is most preferred that no crosslinking aid is contained.

### (Other additives)

To the perfluoroelastomer composition, within a range not to impair the effects of the present invention, additives other than the crosslinking agent, the foaming agent and the crosslinking aid may be blended. As other additives, a filler, an acid acceptor, a processing aid, a plasticizer, a softening agent, an age resistor, a coloring agent, a pigment, a stabilizer, an adhesive, a release agent, a conductivity-imparting agent, a thermal conductivity-imparting agent, a surface non-cohesive agent, a tackifier, a flexibility-imparting agent, a heat resistance improving agent, a flame retardant, an ultraviolet absorber, an oil resistance-improving agent, an antiscorching agent, a lubricant and an antifouling property-improving agent may, for example, be mentioned.

The content of other additives in the perfluoroelastomer composition is, per 100 parts by mass of the perfluoroelastomer, preferably 20 parts by mass or less, more preferably 10 parts by mass or less. It is most preferred that no other additives are contained. By containing no other additives, the requirement of a shore A hardness of 25 or more and 60 or less is likely to be satisfied, and excellent assembling property will be obtained.

As the filler, silica may be mentioned. The content of silica in the perfluoroelastomer composition is, per 100 parts by mass of the perfluoroelastomer, preferably 20 parts by mass or less, more preferably 10 parts by mass or less, further preferably 3 parts by mass or less. It is most preferred that no silica is contained.

In the present invention, "silica" is intended for a substance containing silicon dioxide in an amount of 50% or more, preferably 70% or more, more preferably 90% or more, most preferably 95% or more. Further, in the present invention, "containing no silica" means that per 100 parts by mass of the perfluoroelastomer, the content of silica is 3 parts by mass or less, preferably 1 part by mass or less, more preferably 0.5 parts by mass or less, most preferably 0 parts by mass.

The perfluoroelastomer molded product produced from the perfluoroelastomer composition containing no silica is likely to satisfy the requirement of a shore A hardness of 25 or more and 60 or less, and have excellent assembling property.

As the acid-acceptor, a metal oxide may be mentioned. In a case where the perfluoroelastomer composition contains a metal oxide, its content is, per 100 parts by mass of the perfluoroelastomer, preferably 5 parts by mass or less, more preferably 3 parts by mass or less, most preferably 1 part by mass or less. The perfluoroelastomer molded product produced from the perfluoroelastomer composition having a metal oxide content of 5 parts by mass or less is excellent in plasma resistance and can suppress generation of particles, whereby the contamination of the apparatus can be reduced.

The perfluoroelastomer molded product of the present invention contains no carbon black. The perfluoroelastomer molded product of the present invention, which contains no carbon black, is excellent in plasma resistance and can suppress generation of particles caused by carbon black, whereby contamination of the apparatus can be reduced.

Further, the perfluoroelastomer molded product of the present invention containing no carbon black contributes to satisfaction of the requirement of a shore A hardness of 25 or more and 60 or less and to improvement of assembling property.

### <Method for producing perfluoroelastomer>

The perfluoroelastomer molded product, which is a foam, as a preferred embodiment of the present invention, is obtained preferably by expanding the perfluoroelastomer composition and at the same time crosslinking the perfluoroelastomer in the perfluoroelastomer composition (hereinafter sometimes referred to as expansion and crosslinking).

The perfluoroelastomer molded product is produced preferably by conducting molding at the same time as expansion and crosslinking so that the molded product is in a predetermined shape when the expansion reaction is completed. Although it is possible that the perfluoroelastomer molded product after expansion and crosslinking (for example a sheet-shaped) is further processed e.g. by cutting into a desired shape, the method of molding the perfluoroelastomer composition into a predetermined shape at the same time as expansion is preferred in view of good yield. As the molding method, various method such as pressure molding (compression molding), extrusion and injection molding may be mentioned.

When the perfluoroelastomer composition is heated to a temperature of the decomposition temperature of the foaming agent or higher, expansion reaction occurs, and when heated to a temperature of the decomposition temperature of the crosslinking agent or higher, crosslinking reaction occurs. In the present invention, it is preferred to heat the perfluoroelastomer composition to a temperature of the decomposition temperature of the foaming agent or higher and a temperature of the decomposition temperature of the crosslinking agent or higher, so that expansion reaction and crosslinking reaction proceed at the same time.

The heating may be conducted under elevated pressure or may be conducted under normal pressure.

The crosslinking temperature of the perfluoroelastomer in the perfluoroelastomer composition is preferably within a range of from 100 to 300°C. By heating within the above temperature range, expansion reaction and crosslinking reaction proceed in a well balanced manner, and a perfluoroelastomer molded product excellent in uniformity of the expansion state will be obtained. When the perfluoroelastomer composition is molded under elevated pressure, a perfluoroelastomer molded product excellent in surface smoothness is likely to be obtained. Further, a perfluoroelastomer molded product excellent in physical properties such as tensile break strength and excellent in heat resistance and chemical resistance will be obtained.

Further, by conducting primary heating at a relatively low temperature and secondary heating at a relatively high temperature in combination, the crosslinking reaction will proceed more favorably, and a perfluoroelastomer molded product excellent in mechanical properties will be obtained. The primary heating temperature is preferably from 100 to 250°C. The secondary heating temperature is preferably higher than the primary heating temperature, and the secondary heating temperature is preferably from 150 to 300°C, more preferably from 150 to 250°C, most preferably from 170 to 250°C. The secondary heating temperature is preferably higher than the primary heating temperature by 10°C or more, more preferably by 20°C or more. Further, the secondary heating may be carried out by raising the temperature stepwise. The heating time may optionally be selected.

As specific examples of the combination of primary heating and secondary heating, preferred is a method of carrying out primary heating by hot pressing at from 150 to 200°C for from 3 to 60 minutes to conduct crosslinking and molding, and then heating the obtained molded product in an oven at a temperature higher than the hot pressing temperature and at from 170 to 250°C for from 1 to 24 hours to make the crosslinking reaction further proceed.

Further, cells in the perfluoroelastomer molded product of the present invention may be closed cells or may be open cells. The closed cells are cells not connected to the outside of the foam. The open cells are cells connected to the outside of the foam. In other words, cells the interior of which will be filled with water when the foam is dipped in water are open cells, and cells the interior of which are not filled with water are closed cells.

Further, the perfluoroelastomer molded product which is the foam of the present invention may have a skin layer.

The expansion ratio of the perfluoroelastomer molded product of the present invention is not particularly limited. The expansion ratio may be controlled by molding conditions such as the amount of the foaming agent used, the molding temperature and the molding time. The expansion ratio is defined by [the specific gravity before expansion (the specific gravity of the composition)]÷[the specific gravity after expansion (the specific gravity of the perfluoroelastomer)].

The hardness of the perfluoroelastomer molded product of the present invention is such that the shore A hardness is 25 or more and 60 or less. The shore A hardness may be measured by the method specified by JIS K6253. By the perfluoroelastomer molded product of the present invention having a shore A hardness within the above range, the after-described protective member comprising the perfluoroelastomer molded product of the present invention is excellent in assembling property.

The perfluoroelastomer molded product of the present invention preferably satisfies both folding resistance and moderate resilience when pushed with a tapered jig. When it has sufficient folding resistance, even if the number of insertion operation increases, sealing failure is less likely to occur. Further, when it has sufficient resilience, the molded product is less likely to be destroyed by a tapered jig. The present inventors have found that both requirements are satisfied by the perfluoroelastomer molded product having a shore A hardness of 25 or more and 60 or less.

Further, the perfluoroelastomer molded product of the present invention preferably has a shore A hardness of 25 or more and 60 or less and an asker C hardness of 45 or more and 80 or less, more preferably a shore A hardness of 28 or more and 50 or less and an asker C hardness of 50 or more and 75 or less, most preferably a shore A hardness of 30 or more and 45 or less and an asker C hardness of 55 or more and 70 or less. The asker C hardness may be measured by the method specified by JIS K6253.

The reason why the perfluoroelastomer of the present invention preferably has a shore A hardness of 25 or more and 60 or less and an asker C hardness of 45 or more and 80 or less, will be described with reference to drawings.

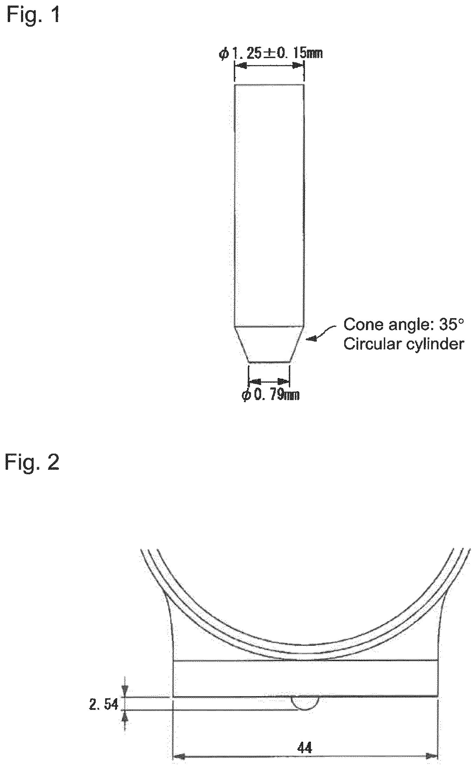

Fig. 1 is a view schematically illustrating a shore A indenter. Fig. 2 is a view schematically illustrating an asker C indenter. The indenter to measure the shore A hardness has a flat tip, the indenter to measure the asker C hardness is semispherical, and the indenters to measure the shore A hardness and the asker C hardness have different shapes. The present inventors have found that when the hardnesses measured by different indenters are respectively within preferred ranges, more excellent folding resistance and resilience are obtained.

### <Protective member>

The protective member of the present invention comprises the above-described perfluoroelastomer molded product of the present invention. The protective member of the present invention may be composed solely of the perfluoroelastomer molded product of the present invention or may have other member in combination.

The protective member of the present invention is used preferably to protect, in a machine which employs plasma or a chemical solution (hereinafter sometimes referred to as machine), a portion which may generate particles by exposure to the plasma or the chemical solution (hereinafter sometimes referred to as particle source). The particle source may, for example, be an adhesive layer containing an adhesive or a shock absorbing layer comprising a shock absorbing material, and as the adhesive or the shock absorbing material, a urethane compound and a silicon compound may, for example, be mentioned.

As the machine, an etching apparatus, a cleaning apparatus, an exposure apparatus, a polishing apparatus, a film-forming apparatus, a liquid treatment apparatus and an analytical instrument may, for example, be mentioned, but the machine is not limited thereto. As specific examples of the machine, a semiconductor production apparatus may be mentioned.

The protective member is suitably used to protect the particle source present in a space in the machine. The space in the machine is generated by members constituting the machine.

An embodiment of the present invention will be described with reference to drawings. However, it should be understood that the present invention is by no means restricted to the drawings.

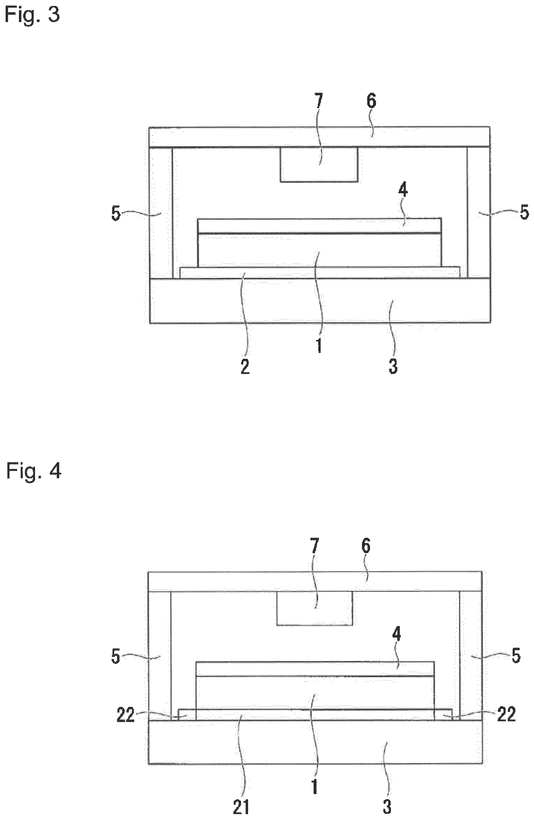

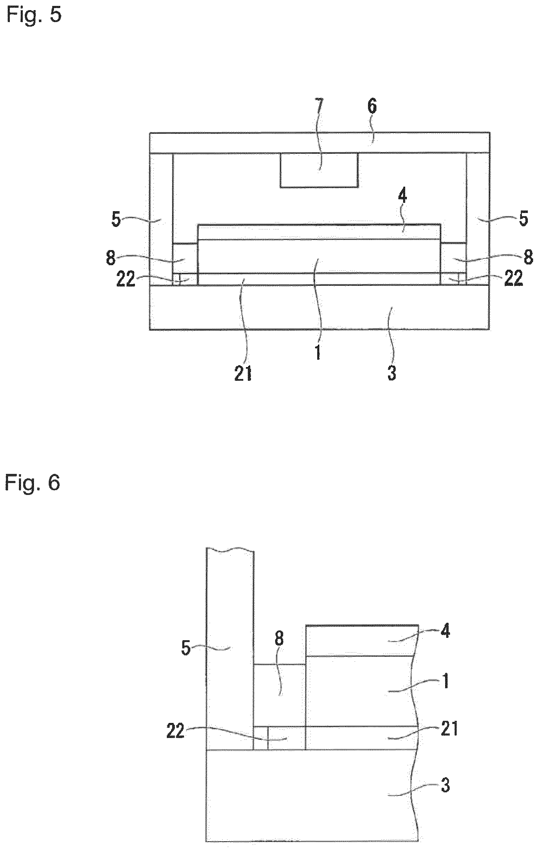

Fig. 3 is a view schematically illustrating a cross section of a semiconductor production apparatus. Fig. 4 is a pattern diagram illustrating a cross section of a semiconductor production apparatus. Fig. 5 is a pattern diagram illustrating an embodiment of a protective member of the present invention. Fig. 6 is a magnification of Fig. 5.

Now, Fig. 3 will be described. A vacuum chamber of a semiconductor production apparatus comprises a ceramic electrostatic chuck 1, an adhesive layer 2, a cooling plate 3, a silicon wafer 4, a vacuum chamber wall 5 (hereinafter sometimes referred to as wall 5), a top plate 6, and a plasma generating mechanism 7.

The ceramic electrostatic chuck 1 is attached to the upper surface of the cooling plate 3 via the adhesive layer 2. The ceramic electrostatic chuck 1 contains alumina as the main component but its material is not limited. The material of the adhesive layer 2 is a urethane compound. The material of the adhesive layer is not particularly limited and as described above, a silicon compound may also be mentioned. The cooling plate 3 is a plate member which is rectangular in a plan view, and contains aluminum as the main component, but its material is not limited. The cooling plate may have a temperature sensor in its interior.

On the upper surface of the ceramic electrostatic chuck 1, the silicon wafer 4 is disposed. The silicon wafer contains silicon as the main component.

The wall 5 stands from the edge of the cooling plate 3 and is disposed to surround the ceramic electrostatic chuck 1, the adhesive layer 2 and the silicon wafer 4. The wall 5 contains aluminum as the main component, but its material is not limited.

The cooling plate 3 is a plate member which is rectangular in a plan view, and the top plate 6 is disposed to cover a space surrounded by the cooling plate 3 and the wall 5. The top plate 6 contains aluminum as the main component, but its material is not limited.

On the lower surface of the top plate 6, the plasma generating mechanism 7 is disposed. The plasma generating mechanism 7 is fixed to the top plate 6 by a screw, but the fixing method is not limited.

The cooling plate 3 and the wall 5, and the wall 5 and the top plate 6, are in contact with each other, respectively, and constitute a vacuum chamber room in the interior of the vacuum chamber.

Now, Fig. 4 will be described. The adhesive layer 2 is classified into an adhesive layer 21 which contributes to adhesion of the ceramic electrostatic chuck 1 to the cooling plate 3, and an adhesive layer 22 which does not contributes to adhesion of the ceramic electrostatic chuck 1 to the cooling plate 3. One side of the adhesive layer 22 is in contact with the cooling plate 3, and the side opposite from the side in contact with the cooling plate 3 of the adhesive layer 22 is exposed to the space in the vacuum chamber without being in contact with the ceramic electrostatic chuck 1. When plasma generated from the plasma generating mechanism 7 is applied to the adhesive layer 22, particles may be generated from the adhesive layer.

Now, Figs. 5 and 6 will be described. The adhesive layer 22 is a particle source and should be protective. Thus, the protective member 8 is disposed so as to protect the adhesive layer 22 in the vacuum chamber to prevent the adhesive layer 22 from being hit by plasma.

The protective member 8 is composed solely of the perfluoroelastomer molded product of the present invention. However, the protective member of the present invention may be composed solely of the perfluoroelastomer molded product of the present invention or may be combined with other member.

The protective member 8 is disposed in a space generated between the ceramic electrostatic chuck 1 and the wall 5. The position where the protective member of the present invention is disposed is not particularly limited so long as it is between the particle source and the plasma application source, the chemical solution supply source or the like, or between the particle source and a place where the plasma or the chemical solution is reflected or splashes.

The ceramic electrostatic chuck 1 and the wall 5, forming the space in which the protective member 8 is disposed, are disposed in parallel with each other at an interval of 15 mm. However, the shape of the space in which the protective member of the present invention is disposed is not particularly limited.

The protective member 8 is in a plate form and has a thickness of 20 mm and a height of 30 mm. In the space of 15 mm formed by the ceramic electrostatic chuck 1 and the wall 5, the protective member 8 having a thickness of 20 mm is disposed. However, the shape of the protective member of the present invention may properly be designed depending upon the place where the protective member is to be disposed. For example, the protective member of the present invention may be a ring-shaped protective member, other than a plate-shaped protective member.

Further, the size (thickness) of the protective member of the present invention is not particularly limited so long as the particle source can be covered. The size (thickness) of the protective member of the present invention is preferably more than 100% and 250% or less, more preferably 105% or more and 200% or less, to the size of the space in which the protective member is to be disposed. When the size (thickness) of the protective member to the size of the space in which the protective member is to be disposed is more than 100% and 250% or less, the space can be filled with the protective member 8 without impairing the assembling property.

For example, when the protective member is disposed in a space of 5 mm, the thickness of the protective member may be from 5.3 mm to 7 mm.

The protective member 8 is in contact with the adhesive layer 22. However, the protective member of the present invention may or may not be in contact with the particle source.

In a case where the protective member is, for example, a laminate of the perfluoroelastomer molded product of the present invention and a member other than the perfluoroelastomer molded product of the present invention, it is preferred that the surface of the perfluoroelastomer molded product of the present invention faces a direction of the plasma application source or the chemical solution supply source, or a place on which the plasma may be reflected or the chemical solution may splash, with a view to preventing generation of particles.

As described above, when the protective member of the present invention is fitted, such is assumed that the protective member is pushed with a tapered jig and inserted into the space. The protective member 8 is pushed by a needle-shaped jig having a sphere with a diameter of 3 mm on its tip and is filled into the space, however, the jig used to fit the protective member of the present invention is not particularly limited.

In the vacuum chamber, only one piece of the protective member of the present invention may be used, or two or more pieces may be used.

Further, for one space in which the protective member of the present invention can be disposed, only one piece of the protective member may be used, or two or more pieces may be used.

Since the protective member of the present invention comprises the perfluoroelastomer molded product of the present invention, it is excellent in plasma resistance and fitting property. By protecting the particle source by the protective member of the present invention, in a vacuum chamber of a semiconductor production apparatus, generation of particles from the particle source can be suppressed.

### EXAMPLES

Now, the present invention will be described in further detail with reference to Examples. However, it should be understood that the present invention is by no means restricted to such specific Examples. Ex. 1, 2 and 3 are Examples of the present invention, and Ex. 4 and 5 are Comparative Examples. The measurement methods and the evaluation methods are as follows.

### [Measurement of hardness]

Of a sheet-shaped perfluoroelastomer molded product having a thickness of 6 mm, the shore A hardness was measured in accordance with JIS K6253. Further, the asker C hardness was measured in accordance with JIS K7312.

### [Fitting property]

Stainless steel plates (thickness: 2 mm, height: 50 mm, width: 50 mm) were placed in parallel with each other to form a space of 5 mm. The degree how easily the perfluoroelastomer (thickness: 6 mm, height: 30 mm, width: 30 mm) could be fitted to the space was evaluated. Evaluation results in Table 1 were based on the following standards.

### (Evaluation standards)

○ ··· easily assembled
× ··· difficult to assemble

### [Plasma resistance]

The mass of a sheet-shaped perfluoroelastomer molded product having a thickness of 2 mm was measured, and then the molded product was irradiated with plasma. The perfluoroelastomer molded product irradiated with plasma was washed with pure water and dried, and its mass was measured again. Evaluation results in Table 1 were based on the following standards.

### (Evaluation standards)

○ ··· mass reduction by irradiation with plasma of 10 mass% or less.
× ··· mass reduction by irradiation with plasma of more than 10 mass%.

The components identified in Table 1 are as follows.
- Perfluoroelastomer: TFE/PMVE=66:34
   Polymerized in accordance the description in WO2010/082633.
- TFE-P copolymer: manufactured by AGC Inc., AFLAS FEPM series 150P, hydrogen atom content: 4 mass%
- Carbon black: manufactured by Ashland, MT-Carbon United N990
- Crosslinking aid: manufactured by Mitsubishi Chemical Corporation, triallyl isocyanurate (TAIC)
- Crosslinking agent: manufactured by Nouryon, Perkadox 14 (a mixture of 40 mass% of 1,3-bis(tert-butylperoxyisopropyl)benzene and 60 mass% of calcium carbonate)
- Foaming agent composition: VP#600 manufactured by Itii Yugengaisha (comprising 50 parts by mass of azodicarbonamide as an organic chemical foaming agent, 40 parts by mass of composite zinc oxide (manufactured by KOMESHO CAUSTIC LIME INDUSTRIAL CO., LTD., composition of ZnO and CaCO₃), 10 parts by mass of uric acid and 5 parts by mass of naphthenic oil (trade name, manufactured by Idemitsu Kosan Co., Ltd., NP-24) (totally 105 parts by mass))
- Processing aid: sodium stearate

### (Ex. 1)

All components identified in Ex. 1 in Table 1 were kneaded by a two roll mill to obtain a composition, which was hot-pressed in a mold having a thickness of 10 mm at 160°C for 13 minutes to conduct primary crosslinking and further at 200°C for 4 hours to conduct secondary crosslinking to obtain a perfluoroelastomer molded product having a thickness of 20 mm.

This perfluoroelastomer molded product was subjected to evaluation of hardness, fitting property and plasma resistance. The results are shown in Table 1.

In Ex. 2, 3, 4 and 5 also, in the same manner as in Ex. 1, a molded product was prepared and evaluated.

In Table 1, the contents of the respective components are represented by parts by mass per 100 parts by mass of the perfluoroelastomer or the TFE-P copolymer.

**[Table 1]**

| | Ex. 1 | Ex. 2 | Ex. 3 | Ex. 4 | Ex. 5 |
|---|---|---|---|---|---|
| Perfluoroelastomer | 100 | 100 | 100 | 0 | 100 |
| TFE-P Copolymer | 0 | 0 | 0 | 100 | 0 |
| Carbon black | 0 | 0 | 0 | 5 | 5 |
| Crosslinking aid | 0.1 | 0.1 | 0.1 | 0.3 | 0.1 |
| Crosslinking agent | 6.3 | 6.3 | 6.3 | 2.5 | 6.3 |
| Foaming agent composition | 0.9 | 0.9 | 0.9 | 1.5 | 0.9 |
| Foaming agent in foaming agent composition | 0.4 | 0.4 | 0.4 | 0.7 | 0.4 |
| Processing aid | 1 | 1 | 1 | 1 | 1 |
| Shore A hardness by JIS K6253 | 25 | 44 | 60 | - | 70 |
| Asker C hardness by JIS K7312 | 45 | 68 | 80 | 12 | - |
| Fitting property | ○ | ○ | ○ | × | × |
| Plasma resistance | ○ | ○ | ○ | × | × |

As evident from the results in Table 1, s containing no carbon black and having a shore A hardness of 25 or more and 60 or less, had favorable fitting property and plasma resistance (Ex. 1, 2 and 3). The molded products excellent in fitting property can protect the particle source. Further, by having plasma resistance, the molded products are suitable for use in a semiconductor production apparatus.

Whereas the molded products in Ex. 4 and 5, containing carbon black, were inferior in fitting property and plasma resistance. If a molded product inferior in fitting property is used, the particle source can not be protected, and the particle source is deteriorated. Further, since the molded product itself is inferior in plasma resistance, it is not suitable for use in a semiconductor production apparatus.

### REFERENCE SYMBOLS

1: ceramic electrostatic chuck
2: adhesive layer
3: cooling plate
4: silicon wafer
5: vacuum chamber wall
6: top plate
7: plasma generating mechanism
8: protective member
21: adhesive layer contributing to adhesion of ceramic electrostatic chuck 1 to cooling plate 3
22: adhesive layer not contributing to adhesion of ceramic electrostatic chuck 1 to cooling plate 3

The entire disclosure of Japanese Patent Application No. 2019-190257 filed on October 17, 2019 including specification, claims, drawings and summary is incorporated herein by reference in its entirety.

## Claims

1. A perfluoroelastomer molded product containing no carbon black, and having a shore A hardness of 25 or more and 60 or less.

2. The perfluoroelastomer molded product according to Claim 1, which contains no silica.

3. The perfluoroelastomer molded product according to Claim 1 or 2, which has an asker C hardness of 45 or more and 80 or less.

4. The perfluoroelastomer molded product according to any one of Claims 1 to 3, which is a foam.

5. The perfluoroelastomer molded product according to any one of Claims 1 to 4, which is obtained from a perfluoroelastomer composition containing a perfluoroelastomer and a crosslinking agent and containing no carbon black.

6. The perfluoroelastomer molded product according to any one of Claims 1 to 5, which is obtained by crosslinking a perfluoroelastomer in a perfluoroelastomer composition containing the perfluoroelastomer, a crosslinking agent and a foaming agent and containing no carbon black.

7. The perfluoroelastomer molded product according to any one of Claims 1 to 6, which has a mass reduction by irradiation with plasma of 10 mass% or less, measured by the following method:
measurement method: the mass of the perfluoroelastomer molded product in a sheet shape having a thickness of 2 mm is measured, the perfluoroelastomer molded product is irradiated with plasma, washed with pure water and dried, and its mass is measured again.

8. The perfluoroelastomer molded product according to any one of Claims 1 to 7, wherein the perfluoroelastomer is a perfluoroelastomer crosslinkable by an organic peroxide.

9. The perfluoroelastomer molded product according to Claim 8, wherein the perfluoroelastomer crosslinkable by an organic peroxide is an elastomer having a perfluoroalkylene group, an elastomer having a perfluoropolyether group or an elastomer having both perfluoroalkylene group and perfluoropolyether group.

10. The perfluoroelastomer molded product according to any one of Claims 1 to 9, wherein the perfluoroelastomer is a copolymer having units based on tetrafluoroethylene and unites based on a perfluoroalkyl vinyl ether.

11. The perfluoroelastomer molded product according to any one of Claims 1 to 10, which has a content of carbon black having a particle size within a range of from 2 nm to 800 nm of 3 parts by mass or less per 100 parts by mass of the perfluoroelastomer.

12. A protective member comprising the perfluoroelastomer molded product as defined in any one of Claims 1 to 11.

13. The protective member according to Claim 12, which has a size of more than 100% and 250% or less to the size of a space in which the protective member is to be disposed.

14. The protective member according to Claim 12 or 13, which is to protect a portion which may generate particles by exposure to plasma or a chemical solution in a machine for which the plasma or the chemical solution is used.

15. The protective member according to any one of Claims 12 to 14, which is a protective member for a semiconductor production apparatus.
